# EUROPEAN PATENT APPLICATION

(11) **EP 1 003 216 A2**
(43) Date of publication of application: **24.05.2000**
(21) Application number: 99308018.3
(22) Date of filing: 12.10.1999
(51) Int. Cl.: H01L 23/538, H01L 25/16

(54) **Multilayered ceramic structure**

(30) Priority: 17.11.1998 US 193655
(71) Applicant: CTS Corporation, Elkhart Indiana 46514-1899 (US)
(72) Inventor: Fisher, Phillip S., Fountain, IN 47918 (US); Jordan, Charles II, Tippecanoe, IN 47906 (US)
(74) Representative: Loven, Keith James

(57) **Abstract**

A multilayered low temperature co-fired ceramic (LTCC) with integral capacit6rs has a number of planar high dielectric constant materials and a number of planar low dielectric constant materials. The low dielectric constant materials are located between the high dielectric constant materials or the high dielectric constant materials may be located between the low dielectric constant material. A pair of electrodes are located on each side of one or more high dielectric constant layers to form a capacitor. A conductor electrically connects to the buried electrode for connection to internal circuitry or to an external connection. The low and high dielectric constant materials are a low temperature co-fired ceramics.

## Description

### FIELD OF THE INVENTION

This invention generally relates to ceramic electronic packaging. Specifically. there is a multilayered low temperature co-fired ceramic (LTCG) base which may have integral capacitors inductors and other passive components mounted therein.

### DESCRIPTION OF THE RELATED ART

Various devices are well known for providing capacitance such as discrete through-hole capacitors, surface mount chip capacitors, and capacitor arrays. These devices typically are mounted onto either the top or bottom layer of a printed circuit board. However, it has been found that this limits the density of components that can be fabricated on a given area. The prior art capacitance devices have been mounted on the top or bottom layer of a low temperature co-fired ceramic (LTCC) substrate. This also limits the density of capacitors that can be fabricated in a given area.

Despite the advantages of the prior art capacitor designs, none have allowed the user to imbed or integrate the capacitors into LTCC structures that can accurately control the capacitance values and minimize distortion and cracking during firing. LTCC tape layers are provided with vias, wiring lines and electrical component bonding pads by conventional thick film screening techniques and then laminated and fired in a low temperature furnace.

US-A-5,144,526, discloses a low temperature co-fired ceramic structure containing buried capacitors.

### SUMMARY OF THE INVENTION

It is a feature of the invention to provide a multilayered low temperature co4ired ceramic (LTCC) with integral capacitors.

A further feature of the invention is to provide a multilayered low temperature cofired ceramic with integral capacitors utilizing high and low dielectric constant material. A number of OW dielectric constant material layers is located between high dielectric constant material layers. Electrodes are located on each side of the high dielectric constant material to form a capacitor. Vias electrically connect with the internal electrode(s) for connection to internal circuitry or routing to external pads. The low and high dielectric constant materials are low temperature co-fired ceramic.

A further feature of the invention is to provide a number of high dielectric constant material layers located between low dielectric constant material layers. Electrodes are located on each side of the high dielectric constant material to form a capacitor. Vias electrically connect to the internal electrodes for connection to internal circuitry or routing to external pads.

One aspect of the invention provides a multilayered low temperature co-fired ceramic, comprising:
a) a first and second low dielectric constant material;
b) a first and second high dielectric constant material located between the first and second low dielectric constant material; and
c) a first and second electrode separated by the first high dielectric constant material.

Another aspect of the invention provides a multilayered low temperature co-fired ceramic with integral capacitors, comprising:
a) a first and second high dielectric constant material;
b) a first and second low dielectric constant material located between the first and second high dielectric constant material; and
c) at least one capacitor formed on the high dielectric constant materials.

Yet another aspect of the invention provides a multilayered low temperature co-fired ceramic with capacitors, comprising:
a) a first, second, third and fourth low dielectric constant layer;
b) a first and second high dielectric constant layer located between the second and third low dielectric constant layer; and
c) at least one capacitor formed on either the first or the second high dielectric constant layer.

### BRIEF DESCRIPTION OF THE DRAWINGS

These and other features of the invention can best be understood by the following description of the accompanying drawings as follows:

FIG. 1 is a side cross sectional view of the preferred embodiment of a multi-layered low temperature co-fired ceramic (LTCO) with integral capacitors.

FIG. 2 is a side cross-sectional view of another embodiment of an LTCC with integral capacitors.

It is noted that the drawings of the invention are not to scale. The drawings are merely schematic representations, not intended to portray specific parameters of the invention. The drawings are intended to depict only typical embodiments of the invention, and therefore should not be considered as limiting the scope of the invention. The invention will be described with additional specificity and detail through the accompanying drawings.

### DETAILED DESCRIPTION OF THE PREFERRED EMBODIMENT

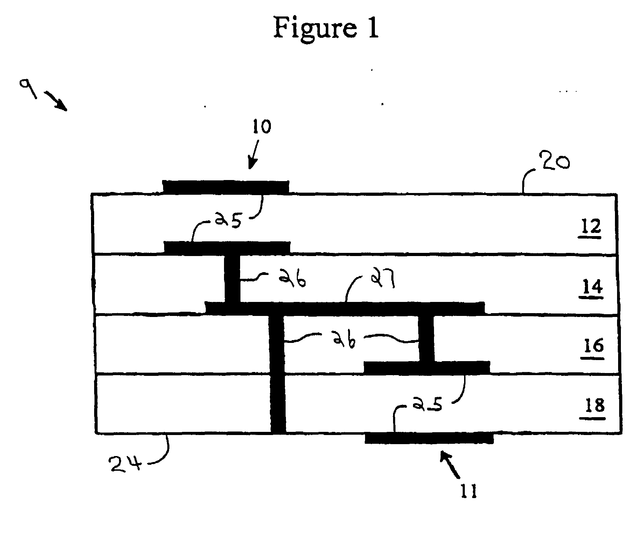

Referring to Figure 1, a side cross sectional view of the preferred embodiment of a multilayered low temperature co4ired ceramic (LTCC) with integral capacitors is shown. A pair of planar high dielectric constant material layers 12 and 18 have a pair of planar low dielectric constant material layers 14 and 16 located in between. If desired, more layers can be added for the low dielectric constant material layers 14 and 16, in this configuration. The ratio of high dielectric layers to low dielectric layers preferably is balanced within the structure, in that, from the middle of the stack of layers, the top half number of layers and their position of low dielectric to high dielectric layers must be a mirror image of the bottom half number of layers and dielectric position. The low and high dielectric constant material layers are conventional LTCC tapes that are commercially available. The low dielectric constant material layers, 14 and 16, preferably have a dielectric constant ranging from 4 to 10. The high dielectric constant material layers, 12 and 18, preferably have a dielectric constant range from greater than 15 to 250. Two pairs of electrodes 25 are located on each side of the high dielectric constant layers 12 and 18 to form capacitors 10 and 11, respectively. Internal electrodes 25 are electrically connected by vias 28 to connect to other internal circuitry (not shown) or the external surfaces, top surface 20 and bottom surface 24. A circuit line 27 can be used to connect to several capacitors or electrodes together. Electrodes 25 vias 26 and circuit lines 27, are made from conventional thick film conductor materials and are applied using conventional thick film screening techniques. Electrodes 25 and vias 26 connect with other circuit lines (not shown) or passive components (not shown) on the LTCC device. Using the structure of figure 1, it is possible, for example to produce buried capacitors with values ranging from .1 picofarads to 5000 picofarads.

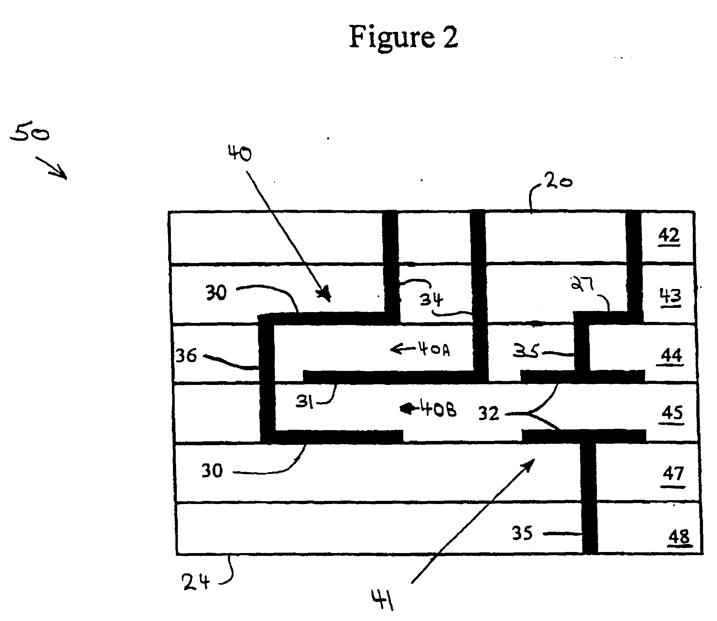

Referring to Figure 2, a side cross-sectional view of another embodiment of an LTCC with integral capacitors assembly 50 is shown. Assembly 50 has capacitors 40 and 41 buried therein. There are four planar low dielectric constant material layers 42, 43, 47 and 48. A pair of planar high dielectric constant materials 44 and 45 are located between low dielectric constant layers 43 and 47. Again, the low and high dielectric constant materials must be balanced within the structure. The low dielectric constant material has a dielectric constant ranging from 4 to 10. The high dielectric constant material has a dielectric constant ranging from greater than 15 to 250. Capacitor 40 has a pair of electrodes 30 located between layers 43 and 44 and 45 and 47, respectively, which are electrically connected by vias 36. A third electrode 3lis located between layers 44 and 45. The electrodes 30, 31 and dielectric 44 form capacitor 40a. The electrodes 30,31 and dielectric 45 form capacitor 40b. With this arrangement, capacitors 40a and 40b are in parallel, creating capacitor 40 and in effect doubling the capacitance value. Connections to internal circuits (not shown) on the external surfaces 20and 24 are made by vias 34 and circuit line 27. Capacitor 41 has a pair of electrodes 32 on both sides of high dielectric constant layer 45. Vias 35 and circuit line 27 connect the capadtor 41 to either internal circuitry (not shown) or the external surfaces 20 and 24. Similar to that shown in Figure 1, electrodes 30,31,32, vias 34,35,36 and circuit line 27 are made of conventional thick film conductor materials that are applied by conventional thick film screening techniques.

Both LTCC assemblies as shown in Figure 1 and Figure 2 can be assembled in the same manner as follows: The first step is to punch vias and fill the vias with a conductive material on each of layers. Next, electrodes and circuit lines (not shown) would be screened onto sides of both high and low dielectric constant material layers. The layers are then stacked, laminated, and fired at approximately 850 degrees centigrade.

The incorporation of different dielectric constant layers allows the fabrication of multi-layered electrical structures that take advantage of each type of layer. For example, capacitors can be made by placing electrodes that sandwich the high dielectric constant material layers and high performance inductors can be fabricated within the low dielectric constant layers to reduce inner winding capacitance. Signal routing can be accomplished primarily within the low dielectric constant materials to reduce unwanted electrical coupling, cross-talk noise, and improve electrical delay within the circuit.

### Variations of the Preferred Embodiment

One of ordinary skill in the arts of capacitor and electronic ceramics design, will realize many advantages from using the pr6ferred embodiment. Further, one of ordinary skill in the art of making capacitors will realise that there are many different ways of accomplishing the preferred embodiment.

Even though, the embodiment discusses having vias extending from electrodes to different sides, it is contemplated to have all the vias extending to the same surface or to different surfaces.

Even though the embodiment discusses the use of low temperature co-fired ceramics, other ceramics could be used such as high temperature ceramics.

The invention is not limited to the fabrication of capacitors and inductors. The higher dielectric constant materials allow smaller distributed structures such as transformers, filters, combiners, couplers and resonators. The lower dielectric constant materials allow signal routing with reduced coupling and cross-talk noise.

If desired, inductors can be imbedded into the low dielectric constant material layers which allows inter-winding capacitance to be reduced and increases the frequency of resonance.

Even though the design shown for the layers was a mirror image of layers about an axis of symmetry, it is contemplated that the layers not be a mirror image of each other.

It was shown that the high dielectric constant materials had a dielectric constant range from 15 to 250. It is contemplated that the material used may have a dielectric constant higher or lower than this range. Similarly, it was shown that the low dielectric constant materials had a dielectric constant range from 4 to 10. It is contemplated that the material used may have a dielectric constant higher or lower than this range.

It was shown that the capacitance values fabricated with the invention have a range of values from 0.1 pf to 5000 pf. It is contemplated to fabricate capacitors having values less than 0.1 pf and greater than 5000 pf.

While the invention has been taught with specific reference to these embodiments, someone skilled in the art will recognize that changes can be made in form and detail without departing from the scope of the invention. The described embodiments are to be considered in all respects only as illustrative and not restrictive.

## Claims

1. A multilayered ceramic structure comprising:
a) at least two layers of high dielectric constant material; and
b) at least two layers of low dielectric constant material;
wherein the layers of high dielectric constant material are located between two layers of low dielectric constant material or the layers of low dielectric constant material are located between two layers of high dielectric constant material.

2. A structure according to Claim 1, wherein the low and high dielectric constant materials are low temperature co-fired ceramic materials.

3. A structure according to Claim 1 or 2, comprising a first and a second electrode separated by one of the layers of high dielectric constant material.

4. A structure according to Claim 3, comprising a conductor, electrically connected to one of the electrodes and extending through at least one layer to the surface of the structure.

5. A structure according to Claim 4, wherein the conductor is a via.

6. A structure according to Claim 4, wherein the conductor is a circuit line.

7. A structure according to any preceding claim, comprising:
a) first, second, third and fourth low dielectric constant layers:
b) first and a second high dielectric constant layers located between the second and third low dielectric constant layers; and
c) first and a second electrode deposited on each side of the second high dielectric constant layer.

8. A structure according to Claim 7, wherein a via electrically connects to the first electrode.

9. A structure according to Claim 7 or 8, wherein a via electrically connects to the second electrode.

10. A structure, according to Claim 3, comprising:
a) a first, second, third and fourth low dielectric constant material layers;
b) a first and second high dielectric constant material layers located between the second and third low dielectric constant material layers;
c) a first electrode deposited on a first side of the second high dielectric constant material layer;
d) a second electrode deposited on a second side of the second high dielectric constant material layer; and
e) a first via electrically connected to the first electrode and extending through the first and second low dielectric constant material layers.

11. A structure according to Claim 10, wherein a second via is electrically connected to the second electrode and extends through the first and second low dielectric constant material layers, and through the first and second high dielectric constant material layers.

12. A structure according to any of Claims 4 to 11, wherein a plurality of passive components are deposited on either the high dielectric constant material layers or the low dielectric constant material layers.

13. A structure according to Claim 12, wherein the passive components are connected to at least one via and/or circuit line.

14. A structure according to Claim 12 or 13, wherein the passive components are selected from the group consisting of:
a) capacitors;
b) resistors;
c) inductors;
d) transformers;
e) combiners;
f) dividers;
g) filters;
h) resonator; and
i) transmission lines.
